# EUROPEAN PATENT SPECIFICATION

(11) **EP 4 276 502 B1**
(45) Date of publication and mention of the grant of the patent: **09.12.2026**
(21) Application number: 23199482.3
(22) Date of filing: 27.02.2020
(51) Int. Cl.: C09K 11/02, B82Y 20/00, C01B 25/08, C09K 11/56, C09K 11/70, C09K 11/88, G02B 5/20

(54) **SEMICONDUCTOR NANOPARTICLES, DISPERSION OF SEMICONDUCTOR NANOPARTICLES, AND OPTICAL MEMBER**
HALBLEITERNANOPARTIKEL, DISPERSION AUS HALBLEITERNANOPARTIKELN UND OPTISCHES ELEMENT
NANOPARTICULES SEMI-CONDUCTRICES, DISPERSION DE NANOPARTICULES SEMI-CONDUCTRICES ET ÉLÉMENT OPTIQUE

(30) Priority: 19.03.2019 JP 2019050709; 12.12.2019 JP 2019224368
(43) Date of publication of application: 15.11.2023
(62) Document number(s) of the earlier application(s) in accordance with Art. 76 EPC: 20773276.9 / 3 943 447
(73) Proprietor: Shoei Chemical Inc., Tokyo 163-0443 (JP)
(72) Inventor: MORIYAMA, Takafumi, Tosu-shi, Saga, 841-0048 (JP); SASAKI, Hirokazu, Tosu-shi, Saga, 841-0048 (JP); MATSUURA, Keisuke, Tosu-shi, Saga, 841-0048 (JP)
(74) Representative: Müller-Boré & Partner Patentanwälte PartG mbB

(56) References cited:
- EP-A1- 3 184 603
- EP-A1- 3 275 967
- WO-A1-2017/188300
- US-A1- 2019 112 527

## Description

### TECHNICAL FIELD

The present invention relates to semiconductor nanoparticles, and a dispersion liquid and an optical member using the semiconductor nanoparticles.

### BACKGROUND ART

Semiconductor nanoparticles (quantum dots: QD) having a microscopic particle diameter are used as a wavelength conversion material for displays. Such semiconductor nanoparticles are microscopic particles that can exhibit a quantum confinement effect and the width of a band gap changes depending on the size of the nanoparticles. Excitons formed in the semiconductor particles by means such as photoexcitation and charge injection emit photons having energy corresponding to the band gap by recombination. Therefore, adjustment of the crystal size of the semiconductor nanoparticles allows the wavelength to be controlled and thus light emission of a desired wavelength to be obtained.

As QD devices using semiconductor nanoparticles, there are QD devices made by a method for whitening blue light by a QD film obtained by forming the semiconductor nanoparticles into a film, and converting the obtained white light into red, green, and blue through a color filter (a QD film method) and QD devices made by a method of directly converting blue light into red and green by a QD color filter using the semiconductor nanoparticles (a QD color filter method).

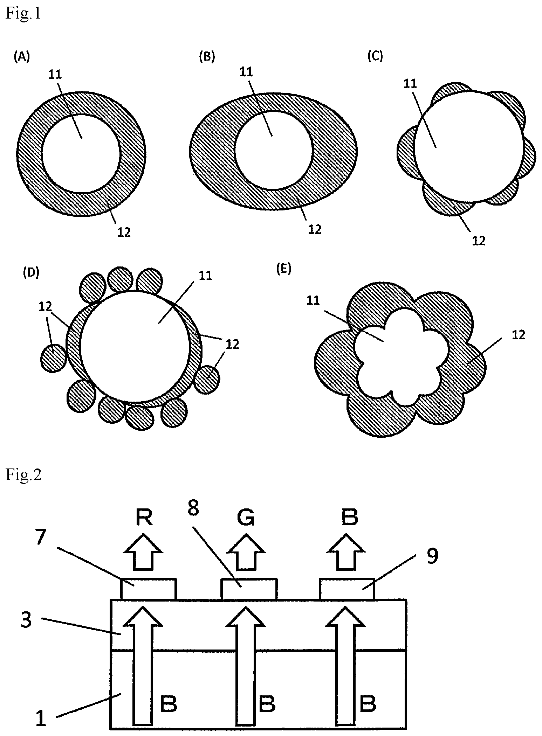

One example of the device configuration of the QD color filter type QD device will be described with reference to FIG. 2. As illustrated in FIG. 2, QD patterns (7 and 8) are used to directly convert blue light to red light or blue light to green light without converting the blue light from a blue LED 1 serving as a light source into white light. The QD patterns (7 and 8) are formed by patterning the semiconductor nanoparticles dispersed in a resin and the thickness thereof is about 5 ~ 10 µm due to the structural limitation of the display. With respect to blue, blue light from the blue LED 1 serving as a light source transmitted through a diffusion layer 9 including a diffusing agent is used. Reference sign 3 is a liquid crystal and the polarizing plate is omitted in FIG. 2.

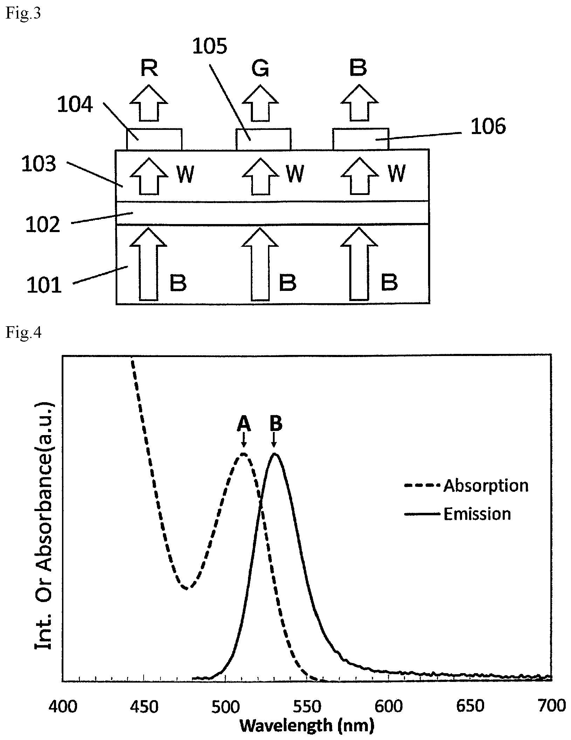

One example of the device configuration of the QD film type QD device will be described with reference to FIG. 3. As illustrated in FIG. 3, a blue LED 101 is used as a light source. First, the blue light is converted into white light. For the conversion from blue light to white light, a QD film 102 made by dispersing the semiconductor nanoparticles in a resin to form a film having a thickness of about 100 µm is suitably used. The white light obtained by the wavelength conversion layer such as the QD film 102 is further converted into red light, green light, and the blue light with a color filter (R) 104, a color filter (G) 105, a color filter (B) 106, respectively. Reference sign 103 is a liquid crystal and the polarizing plate is omitted in FIG. 3.

Of these methods, the QD color filter method directly converts the blue light into each color and thus the wavelength conversion efficiency of the entire QD device is high. Therefore, in recent years, the QD color filter method has attracted attention.

Under such background, the semiconductor nanoparticles are originally required to have high quantum yield in order to increase the wavelength conversion efficiency of the QD device and to have a narrow full width at half maximum in order to prevent color mixing.

As the semiconductor nanoparticles, Cd chalcogenide semiconductor nanoparticles and semiconductor nanoparticles using InP as a base material have been known (for example, Patent Literatures 1 to 3). Conventionally, a lot of research has been conducted on Cd-based semiconductor nanoparticles. This is because the Cd-based semiconductor nanoparticles have high quantum yield and in addition change in the emission wavelength caused by change in the particle diameter is relatively gentle and thus the emission wavelength can be easily controlled.

In recent years, however, the development of non-Cd-based semiconductor nanoparticles has been desired in consideration of adverse effects on the environment and the human body. Examples of the non-Cd-based semiconductor nanoparticles include semiconductor nanoparticles using InP as the base material. The semiconductor nanoparticles using InP as the base material, however, have lower quantum yield than that of the Cd-based semiconductor nanoparticles and the change in emission wavelength caused by the change in the particle diameter is large, and thus a problem of difficulty in the control of the emission wavelength arises.

Therefore, the following attempts have been made for the InP-based semiconductor nanoparticles. For example, Patent Literature 4 has disclosed semiconductor nanoparticles having a core-shell structure (hereinafter, also referred to as an InP/ZnSe ·ZnS core/shell structure) formed of a core made of InP and a shell made of ZnSe and ZnS and attempts have been made to improve absorbance. Patent Literature 5 has disclosed semiconductor nanoparticles in which an InP/ZnSe ·ZnS core/shell structure includes a halogen and attempts have been made to improve quantum yield. Patent Literature 6 has disclosed semiconductor nanoparticles having a core-shell structure (hereinafter, also referred to as an InP/ZnSe ·ZnS core/shell structure) formed of a core made of InP and a shell made of ZnSe and ZnS and attempts have been made to improve quantum yield and to narrow the full width at half maximum. Patent Literature 7 describes quantum dots and devices including the same. Patent Literature 8 describes quantum dot material and method for producing quantum dot material.

### Citation List

### Patent Literature

Patent Literature 1: U. S. Patent Application Publication No. 2015/083969
Patent Literature 2: U. S. Patent No. 9169435
Patent Literature 3: U. S. Patent No. 9884993
Patent Literature 4: U. S. Patent Application Publication No. 2017/0306227
Patent Literature 5: U. S. Patent Application Publication No. 2015/0083969
Patent Literature 6: U. S. Patent Application Publication No. 2018/0301592
Patent Literature 7: EP 3 184 603 A1
Patent Literature 8: WO 2017/188300 A1

### Summary

### Technical Problem

As one type of the InP-based semiconductor nanoparticles, semiconductor nanoparticles having a core/shell structure formed of a core made of InP and a shell made of ZnSe or ZnSe and ZnS are exemplified. In such semiconductor nanoparticles, ZnSe or ZnSe and ZnS constituting the shell are a combination of the 12^{th} group and the 16^{th} group and thus a plurality of defect levels are formed between the core and the shell when the core/shell structure is tried to form with InP, which is made of a combination of the 13^{th} group and the 15^{th} group. Existence of these defect levels causes the width of the emission wavelength to be widened and thus the full width at half maximum to be widened. Therefore, the semiconductor nanoparticles having an InP/ZnSe or ZnSe and ZnS core/shell structure are required to have few defect levels.

The generation of the defect levels causes the emission wavelength to be shifted to the longer wavelength side relative to the absorption wavelength, and the Stokes shift, which is the difference between the peak wavelength of the emission spectrum and the peak wavelength of the absorption spectrum of the semiconductor nanoparticles, to be large. Therefore, reduction in the number of the defect levels allows the Stokes shift of semiconductor nanoparticles to be small. Large Stokes shift causes the emission wavelength to be excessively shifted to the long wavelength side and thus a problem in that a desired emission wavelength cannot be obtained arises. Therefore, the semiconductor nanoparticles having the InP/ZnSe or ZnSe and ZnS core/shell structure preferably have small Stokes shift.

In addition, as described above, the semiconductor nanoparticles are inherently required to have high quantum yield and further improvement in quantum yield is required.

In recent years, a color gamut standard called "BT.2020" has been adopted for 4K/8K broadcasting, UHD Blu-ray, and movie theater color gamut standards. In order to satisfy the color gamut standard of "BT.2020", it is necessary that the blue emission is 467 nm, the green emission is 532 nm, and the red emission is 630 nm. Namely, in the color gamut standard of "BT.2020", the wavelength of the green emission is remarkably shorter than that of the color gamut standard of "BT.709" adopted as the current color gamut standard for television broadcasting.

In the case where the semiconductor nanoparticles are used in the QD device, the emission wavelength emitted by the QD device tends to be longer than the emission wavelength of the semiconductor nanoparticles themselves used in the QD device. Therefore, in order to set the green emission of the QD device to 532 nm, the green emission wavelength of the semiconductor nanoparticles is required to be 532 nm or less.

The semiconductor nanoparticles disclosed in Patent Literatures 4 to 6, however, have not been capable of achieving the green emission having a wavelength of 532 nm or less caused by excitation with blue light of 450 nm.

Therefore, an object of the present invention is to provide core/shell type semiconductor nanoparticles that include a core including In and P and a shell including Zn and Se as main components, and have high quantum yield, a small full width at half maximum, and small Stokes shift. Another object of the present invention is to provide core/shell type semiconductor nanoparticles that include a core including In and P and a shell including Zn and Se as main components, and have high quantum yield, a small full width at half maximum, and small Stokes shift and, in addition, are capable of emitting green light having a wavelength of 532 nm or less caused by excitation with blue light of 450 nm.

### Solution to Problem

As a result of intensive study for solving the above-described problems, the inventors of the present invention have found that core/shell type semiconductor nanoparticles including InP as the core and at least ZnSe as the shell having high quantum yield, a small half width at half maximum, and small Stokes shift and, in addition, being capable of emitting green light having a wavelength of 532 nm or less caused by excitation with blue light of 450 nm can be provided by including an appropriate amount of halogen to the semiconductor nanoparticles, increasing the content of Se of the shell layer, and setting the Zn and Se of the shell layer to a specific range. Consequently, the present invention has been attained.

The present invention is defined in the appended claims.

### Advantageous Effects of Invention

According to the present invention, core/shell type semiconductor nanoparticles that include the core including In and P and the shell including Zn and Se as main components, and have high quantum yield, a small full width at half maximum, and small Stokes shift, can be provided. In addition, according to the present invention, core/shell type semiconductor nanoparticles that include the core including In and P and the shell including Zn and Se as main components, and have high quantum yield, a small full width at half maximum, and small Stokes shift and, in addition, are capable of emitting green light having a wavelength of 532 nm or less caused by excitation with blue light of 450 nm, can be provided.

### Brief Description of Drawings

FIG. 1 is a schematic view illustrating an example of an embodiment of the semiconductor nanoparticles.
FIG. 2 is a schematic view illustrating a QD device.
FIG. 3 is a schematic view illustrating a QD device.
FIG. 4 is a graph illustrating the outline of an example of the absorption spectrum and emission spectrum of the semiconductor nanoparticles that are related to the embodiment of the present invention.

### Description of Embodiment

The semiconductor nanoparticles according to the first embodiment described herein is the core/shell type semiconductor nanoparticles, comprising: a core comprising In and P; and a shell having one or more layers, in which
the semiconductor nanoparticles further comprise at least Zn, Se, and halogen, and
in the semiconductor nanoparticles, molar ratios of P, Zn, Se, and halogen each relative to In in terms of atoms are P: 0.20 ~ 0.95, Zn: 11.00 ~ 50.00, Se: 7.00 ~ 25.00, and halogen: 0.80 ~ 15.00.

Hereinafter, a sign "~" representing the value range represents before and after the sign "~" unless otherwise specified. Namely, the phrase ∘ ~ Δ refers to ∘ or more and Δ or less.

The semiconductor nanoparticles according to the first embodiment described herein are semiconductor nanoparticles having a core/shell type structure including the core and one or more layers of the shell. In the semiconductor nanoparticles according to the first embodiment described herein , the shell may have at least one layer. Examples of the semiconductor nanoparticles according to the first embodiment described herein include core/shell type semiconductor nanoparticles including the core and a one-layer shell, core/shell type semiconductor nanoparticles including the core and a two-layer shell, and core/shell type semiconductor nanoparticles including a core and a three or more-layer shell. In the case where the semiconductor nanoparticles according to the first embodiment described herein have the one-layer shell, the concentration of each element in the entire shell may be uniform or the shell may have a concentration gradient in the radial direction. In the case where the semiconductor nanoparticles according to the first embodiment described herein have a plurality of layers of shell, the concentration of each element may be uniform in each shell or the shell may have a concentration gradient in the radial direction.

Examples of the structure of the semiconductor nanoparticles according to the first embodiment described herein are illustrated in FIG. 1A to FIG. 1E. FIG. 1A to FIG. 1E are schematic sectional views illustrating the semiconductor nanoparticles according to the first embodiment described herein. In FIG. 1A to FIG. 1E, the semiconductor nanoparticles include the core 11 (white portion in the view) and the shell 12 (hatched portion in the view). As illustrated in FIGS. 1A and 1B, the semiconductor nanoparticles can have a structure in which the shell 12 covers the entire surface of the core 11. As illustrated in FIG. 1C, the semiconductor nanoparticles can also have a structure in which the shell 12 exists at the parts of the surface of the core 11 in an islandlike shape. As illustrated in FIG. 1D, the semiconductor nanoparticles can also have a structure in which the shell 12 adheres to the surface of the core 11 as nanoparticles to cover the core 11. As illustrated in FIG. 1E, the core 11 of the semiconductor nanoparticles does not required to have a spherical shape. As the structure of the semiconductor nanoparticles, the structures in which the shell covers the entire surface of the core as illustrated in FIGS. 1A and 1B are preferable and the structure in which the shell uniformly covers the entire surface of the core as illustrated in FIG. 1A is particularly preferable.

The semiconductor nanoparticles according to the first embodiment described herein include at least In, P, Zn, Se, and halogen.

The core according to the semiconductor nanoparticles according to the first embodiment described herein includes at least In and P. The core is mainly made of In and P. The core may unavoidably or intentionally include Zn, S, Si, N, and the like in addition to In and P in a range as long as the effects of the present invention are not impaired. The core may include Zn and Se diffused from the shell. The average particle diameter of the core is preferably 1.0 ~ 5.0 nm. The semiconductor nanoparticles having an average particle diameter of the core of 1.0 ~ 5.0 nm allow the excitation light of 450 nm to be converted into the light having a wavelength of 500 ~ 650 nm. In the present invention, the average particle diameter of the core is determined by calculating the particle diameters of 10 or more particles as the area equivalent diameter (Heywood diameter) from the particle image observed by a transmission electron microscope (TEM).

The shell according to the semiconductor nanoparticles according to the first embodiment described herein includes at least Zn and Se. The shell mainly includes Zn and Se. The shell may unavoidably or intentionally include S, Te, Si, Ti, Al, N, and the like in addition to Zn and Se in a range as long as the effects described herein are not impaired. In particular, S is effective for increasing the weather resistance of semiconductor nanoparticles. Te is effective for increasing the absorbance of the semiconductor nanoparticles and is preferably added in a molar ratio of 0.00 ~ 0.50 relative to the molar amount of Se. Examples of the embodiment of the shell include a shell formed of ZnSe. Examples of the embodiment of the shell also include a shell in which the shell has two or more layers and at least one layer is formed of ZnSe. Example of the embodiment of the shell also include a shell that has two or more layers and in which at least one layer is formed of a shell including Zn and Se and the outermost layer is formed of ZnS. Examples of the embodiment of the shell also include a shell having at least a first shell formed of ZnSe and covering the outer surface of the core and a second shell formed of ZnS and covering the outer surface of the first shell. The double-structured shell including the first shell formed of ZnSe and covering the outer surface of the core and the second shell formed of ZnS and covering the outer surface of the first shell is preferable. The first shell may include S, Te, Si, Ti, Al, N, and the like in addition to Zn and Se. The second shell may include Se, Te, Si, Ti, Al, N, and the like in addition to Zn and S.

The semiconductor nanoparticles according to the first embodiment described herein include halogen. The inventors of the present invention presume that the halogen fills a dangling bond as a link between In³⁺ and Zn²⁺ and has an effect of enhancing the confinement effect to anions. Therefore, the semiconductor nanoparticles according to the first embodiment described herein includes the halogen on the outer surface of the core particles, whereby the dangling bond is filled with the halogen and thus the defect level disappears. As a result, the full width at half maximum becomes narrow. Examples of the halogen include Cl, Br, and I. As the halogen, Cl and Br are preferable among these elements in that the effect in which the full width at half maximum narrows and the Stokes shift is reduced is enhanced. As described above, in the present application, the Stokes shift refers to the difference between the peak wavelength of the emission spectrum and the peak wavelength of the absorption spectrum. In the semiconductor nanoparticles according to the first embodiment described herein, the halogen may exist inside the core particles, on the outer surface of the core particles, inside the shell, or on the outer surface of the shell. In particular, the existence of the halogen on the outer surface of the core particles or inside the shell allows the effect in which the full width at half maximum narrows and the Stokes shift is reduced to be exhibited more. Of the semiconductor nanoparticles having the same emission wavelength, the semiconductor nanoparticles having a smaller Stokes shift can obtain the effect of efficiently absorbing the excitation light. In particular, the semiconductor nanoparticles having a green emission wavelength of 532 nm or less further provide this effect.

In the semiconductor nanoparticles according to the first embodiment described herein, the molar ratio of P relative to In in terms of atoms is 0.20 ~ 0.95 and preferably 0.40 ~ 0.95. The semiconductor nanoparticles having the molar ratio of P relative to In in the above range allow the quantum yield to be high, the full width at half maximum to be small, and the Stokes shift to be small.

In the semiconductor nanoparticles according to the first embodiment described herein, the molar ratio of Zn relative to In in terms of atoms is 11.00 ~ 50.00 and preferably 12.00 ~ 30.00. The semiconductor nanoparticles having the molar ratio of Zn relative to In in the above range allow the quantum yield to be high, the full width at half maximum to be small, and the Stokes shift to be small.

In the semiconductor nanoparticles according to the first embodiment described herein, the molar ratio of Se relative to In in terms of atoms is 7.00 ~ 25.00 and preferably 11.00 ~ 20.00. The semiconductor nanoparticles having the molar ratio of Se relative to In in the above range allow the quantum yield to be high, the full width at half maximum to be small, and the Stokes shift to be small.

In the semiconductor nanoparticles according to the first embodiment described herein, the molar ratio of the halogen relative to In in terms of atoms is 0.80 ~ 15.00 and preferably 1.00 ~ 15.00. The semiconductor nanoparticles having the molar ratio of the halogen relative to In in the above range allow the quantum yield to be high, the full width at half maximum to be small, and the Stokes shift to be small. In the case where the semiconductor nanoparticles according to the first embodiment described herein include two or more kinds of halogens, the molar ratio of the halogen relative to In refers to the sum of the molar ratios of two or more kinds of halogen relative to In.

The semiconductor nanoparticles according to the first embodiment described herein having molar ratios of P, Zn, Se, and halogen each relative to In in terms of atoms of P: 0.40 ~ 0.95, Zn: 12.00 ~ 30.00, Se: 11.00 ~ 20.00, and halogen: 1.00 ~ 15.00 tend to easily obtain the light emission of green light of 515 nm ~ 532 nm when excited by light of 450 nm.

In the case where the semiconductor nanoparticles according to the first embodiment described herein include S atoms, the S content in the semiconductor nanoparticles according to the first embodiment described herein in the molar ratio of S relative to In in terms of atoms is preferably 0.00 ~ 45.00, more preferably 0.00 ~ 30.00, and particularly preferably 0.00 ~ 20.00. In the conventional InP/ZnSe ·ZnS semiconductor nanoparticles, it has been conceivable that the decrease in the quantum yield of the semiconductor nanoparticles is reduced by serving a ZnS layer as the outmost layer. According to the present embodiment, however, high quantum yield can be retained without forming the ZnS layer serving as the outermost layer. The semiconductor nanoparticles according to the first embodiment described herein including S and forming the outermost layer shell with ZnS are preferable in that the weather resistance of the semiconductor nanoparticles is improved.

In the semiconductor nanoparticles according to the first embodiment described herein, the total value of the molar ratio of Zn relative to In, the molar ratio of Se relative to In, and the molar ratio of S relative to In in terms of atoms is preferably 20.00 ~ 100.00. The semiconductor nanoparticles having the total value of the molar ratio of Zn relative to In, the molar ratio of Se relative to In, and the molar ratio of S relative to In in the above range provide the effect in which the quantum yield is high, the full width at half maximum is small, and the Stokes shift is small, and in addition the weather resistance is improved. In the semiconductor nanoparticles according to the first embodiment described herein, an increase in the total value of the molar ratio of Zn relative to In, the molar ratio of Se relative to In, and the molar ratio of S relative to In in terms of atoms refers to a relative increase in the thickness of the shell relative to the diameter of the core.

The Cd content of the semiconductor nanoparticles according to the first embodiment described herein is 100 ppm by mass or less, preferably 80 ppm by mass or less, and particularly preferably 50 ppm by mass or less.

The average particle diameter of the semiconductor nanoparticles according to the first embodiment described herein is not particularly limited and is preferably 1.0 ~ 20.0 nm and particularly preferably 1.0 ~ 10.0 nm. In the present invention, the average particle diameter of the semiconductor nanoparticles is determined by calculating the particle diameters of 10 or more particles as the area equivalent diameter (Heywood diameter) from the particle image observed by a transmission electron microscope (TEM).

In the semiconductor nanoparticles according to the first embodiment described herein, the difference between the peak wavelength of the emission spectrum when the semiconductor nanoparticles are excited at 450 nm and the peak wavelength of the absorption spectrum is preferably 23 nm or less and particularly preferably 21 nm or less. The semiconductor nanoparticles having the difference between the peak wavelength of the emission spectrum when the semiconductor nanoparticles are excited at 450 nm and the peak wavelength of the absorption spectrum within the above range allow a desired emission wavelength to be easily obtained and, in particular, light emission having a wavelength of 532 nm or less in green emission to be easily obtained.

The full width at half maximum (FWHM) of the emission spectrum of the semiconductor nanoparticles according to the first embodiment described herein is preferably 35 nm or less and particularly preferably 33 nm or less. The semiconductor nanoparticles having the full width at half maximum of the emission spectrum within the above range allow high-purity light emission to be obtained at a desired emission wavelength.

The quantum yield (QY) of the semiconductor nanoparticles according to the first embodiment described herein is preferably 80% or more and particularly preferably 83% or more.

The semiconductor nanoparticles according to the second embodiment of the present invention are core/shell type semiconductor nanoparticles, comprising:
a core comprising In and P; and a shell having one or more layers, in which
at least one layer of the shell is formed of ZnSe,
the semiconductor nanoparticles further comprise halogen,
a molar ratio of the halogen relative to In in terms of atoms is 0.80 ~ 15.00, and
a difference between a peak wavelength of an emission spectrum when the semiconductor nanoparticles are excited at 450 nm and a peak wavelength of an absorption spectrum of the semiconductor nanoparticles is 23 nm or less.

The semiconductor nanoparticles according to the second embodiment of the present invention are semiconductor nanoparticles having a core/shell type structure including the core and one or more layers of shell. In the semiconductor nanoparticles according to the second embodiment of the present invention, the shell may have at least one layer. Examples of the semiconductor nanoparticles according to the second embodiment of the present invention include core/shell type semiconductor nanoparticles including a core and a one-layer shell, core/shell type semiconductor nanoparticles including the core and a two-layer shell, and core/shell type semiconductor nanoparticles including a core and a three or more-layer shell. The core/shell type structure of the semiconductor nanoparticles according to the second embodiment of the present invention are the same as the core/shell type structure of the semiconductor nanoparticles according to the first embodiment described herein.

The core according to the semiconductor nanoparticles according to the second embodiment of the present invention includes at least In and P. Namely, the core is mainly made of In and P. The core may unavoidably or intentionally include Si, Ti, Al, N, and the like in addition to In and P in a range as long as the effects of the present invention are not impaired. The average particle diameter of the core is preferably 1.0 ~ 5.0 nm. The semiconductor nanoparticles having an average particle diameter of the core of 1.0 ~ 5.0 nm allow the excitation light of 450 nm to be converted into the light having a wavelength of 500 ~ 650 nm. In the present invention, the average particle diameter of the core is determined by calculating the particle diameters of 10 or more particles as the area equivalent diameter (Heywood diameter) from the particle image observed by a transmission electron microscope (TEM).

In the shell according to the semiconductor nanoparticles according to the second embodiment of the present invention, at least one layer is formed of ZnSe. The shell may unavoidably or intentionally include S, Te, Si, Ti, Al, N, and the like in addition to Zn and Se in a range as long as the effects of the present invention are not impaired. In particular, Te is effective for increasing the absorbance of the semiconductor nanoparticles and is preferably added in a molar ratio of 0.00 ~ 0.50 relative to the molar amount of Se. S and Zn form ZnS and are effective for improving the weather resistance of semiconductor nanoparticles.

The semiconductor nanoparticles according to the second embodiment of the present invention include halogen. Examples of the halogen include Cl, Br, and I. As the halogen, Cl and Br are preferable among these elements in that the effect in which the full width at half maximum narrows and the Stokes shift is reduced is enhanced. The position where the halogen exists in the semiconductor nanoparticles according to the second embodiment of the present invention is the outer surface of the core particle. The existence of the halogen at least at the outer surface of the core particle allows the effect in which the full width at half maximum narrows and the Stokes shift is reduced to be enhanced. Of the semiconductor nanoparticles having the same emission wavelength, the semiconductor nanoparticles having a smaller Stokes shift can obtain the effect of efficiently absorbing the excitation light. In particular, the semiconductor nanoparticles having a green emission wavelength further provide this effect.

In the semiconductor nanoparticles according to the second embodiment of the present invention, the molar ratio of Se relative to In in terms of atoms is 7.00 ~ 25.00 and preferably 11.00 ~ 20.00. The semiconductor nanoparticles having the molar ratio of Se relative to In in the above range allow the quantum yield to be high, the full width at half maximum to be small, and the Stokes shift to be small.

In the semiconductor nanoparticles according to the second embodiment of the present invention, the molar ratio of the halogen relative to In in terms of atoms is 0.80 ~ 15.00 and preferably 1.00 ~ 15.00. The semiconductor nanoparticles having the molar ratio of the halogen relative to In in the above range allow the quantum yield to be high, the full width at half maximum to be small, and the Stokes shift to be small. In the case where the semiconductor nanoparticles according to the second embodiment of the present invention include two or more kinds of halogens, the molar ratio of halogen relative to In refers to the sum of the molar ratios of two or more kinds of halogen relative to In.

In the semiconductor nanoparticles according to the second embodiment of the present invention, the molar ratio of P relative to In in terms of atoms is 0.20 ~ 0.95 and preferably 0.40 ~ 0.95. The semiconductor nanoparticles having the molar ratio of P relative to In in the above range allow the quantum yield to be high, the full width at half maximum to be small, and the Stokes shift to be small.

In the semiconductor nanoparticles according to the second embodiment of the present invention, the molar ratio of Zn relative to In in terms of atoms is 11.00 ~ 50.00 and preferably 12.00 ~ 30.00. The semiconductor nanoparticles having the molar ratio of Zn relative to In in the above range allow the quantum yield to be high, the full width at half maximum to be small, and the Stokes shift to be small.

The average particle diameter of the semiconductor nanoparticles according to the second embodiment of the present invention is not particularly limited and is preferably 1.0 ~ 20.0 nm and particularly preferably 1.0 ~ 10.0 nm.

In the semiconductor nanoparticles according to the second embodiment of the present invention, the difference between the peak wavelength of the emission spectrum when the semiconductor nanoparticles are excited at 450 nm and the peak wavelength of the absorption spectrum is preferably 23 nm or less and particularly preferably 21 nm or less. The semiconductor nanoparticles having the difference between the peak wavelength of the emission spectrum when the semiconductor nanoparticles are excited at 450 nm and the peak wavelength of the absorption spectrum within the above range allow a desired emission wavelength to be easily obtained and, in particular, light emission having a wavelength of 532 nm or less in green emission to be easily obtained.

The full width at half maximum (FWHM) of the emission spectrum of the semiconductor nanoparticles according to the second embodiment of the present invention is preferably 35 nm or less and particularly preferably 33 nm or less. The semiconductor nanoparticles having the full width at half maximum of the emission spectrum within the above range allow high-purity light emission to be obtained at a desired emission wavelength.

The quantum yield (QY) of the semiconductor nanoparticles according to the second embodiment of the present invention is preferably 80% or more and particularly preferably 83% or more.

In the semiconductor nanoparticles according to the first embodiment described herein and the semiconductor nanoparticles according to the second embodiment of the present invention, the surface of the shell may be modified with a ligand in order to stabilize the dispersion into the matrix. In order to enhance the dispersibility in solvents having different polarities, the ligand modifying the semiconductor nanoparticles according to the first embodiment described herein or the semiconductor nanoparticles according to the second embodiment of the present invention may be exchanged for another ligand, if necessary. The semiconductor nanoparticles according to the first embodiment described herein or the semiconductor nanoparticles according to the second embodiment of the present invention modified with a ligand can also be bound to other structures through the ligand.

The semiconductor nanoparticles according to the first embodiment described herein and the semiconductor nanoparticles according to the second embodiment of the present invention may have an oxide layer on the surface. The oxide forming the oxide layer is not particularly limited as long as the effect of the present invention is exhibited. Examples thereof include oxides of Si, Ti, and Al.

An example of a method for producing the semiconductor nanoparticles according to the first embodiment described herein and the semiconductor nanoparticles according to the second embodiment of the present invention will be described below. The method for producing semiconductor nanoparticles described below is an example and the semiconductor nanoparticles according to the first embodiment described herein and the semiconductor nanoparticles according to the second embodiment of the present invention are not limited to the semiconductor nanoparticles produced by the following production methods.

An In precursor, a P precursor, a Zn precursor, a Se precursor, a S precursor, and a halogen precursor according to the example of the method for producing semiconductor nanoparticles according to the present invention are as follows.

The In precursor is not particularly limited and examples thereof include indium carboxylates such as indium acetate, indium propionate, indium myristate, and indium oleate, indium halides such as indium fluoride, indium bromide, and indium iodide, indium thiolate, and trialkyl indiums.

The P precursor is not particularly limited and examples thereof include tris(trimethylsilyl) phosphine, tris(trimethylgelmil) phosphine, tris(dimethylamino) phosphine, tris(diethylamino) phosphine, tris(dioctylamino) phosphine, trisalkylphosphines, and PH₃ gas. In the case where tris(trimethylsilyl) phosphine is used as the P precursor, Si may be incorporated into the semiconductor nanoparticles. However, this does not impair the action of the present invention.

The Zn precursor is not particularly limited and examples thereof include zinc carboxylates such as zinc acetate, zinc propionate, zinc myristate, and zinc oleate and zinc halides such as zinc fluoride, zinc bromide, and zinc iodide.

The Se precursor is not particularly limited and examples thereof include trialkylphosphine selenides and selenol.

The S precursor is not particularly limited and examples thereof include trioctylphosphine sulfide, tributylphosphine sulfide, thiols, and bis(trimethylsilyl) sulfide.

The halogen precursor is not particularly limited and examples thereof include HF, HCl, HBr, HI, carboxylic acid halides such as oleoyl chloride, oleoyl bromide, octanoyl chloride, and octanoyl bromide, and metal halides such as zinc chloride, indium chloride, and gallium chloride.

### <Synthesis of core particles>

The core particles are synthesized by reacting the In precursor with the P precursor. First, the In precursor and a solvent are mixed and the In-precursor solution to which a dispersing agent and/or an additive is added, if necessary, is mixed under vacuum. The resultant mixture is once heated at 100 ~ 300°C for 6 ~ 24 hours and thereafter the P precursor is added. The obtained mixture is heated at 200 ~ 400°C for several seconds (for example, 2 or 3 seconds) ~ 60 minutes and thereafter cooled to give a core particle dispersion liquid in which the core particles are dispersed. Subsequently, the halogen precursor is added to the core particle dispersion liquid and the resultant mixture is heated at 25 ~ 300°C for several seconds (for example, 2 or 3 seconds) ~ 60 minutes and thereafter cooled to give a halogen-added core particle dispersion liquid having the halogen on a part of the surface of the particles.

The dispersing agent is not particularly limited and examples thereof include carboxylic acids, amines, thiols, phosphines, phosphine oxides, phosphines, and phosphonic acids. The dispersing agent can also serve as a solvent. The solvent is not particularly limited and examples thereof include 1-octadecene, hexadecane, squalane, oleylamine, trioctylphosphine, and trioctylphosphine oxide. Examples of the additive include the S precursor, the Zn precursor, and the halogen precursor.

### <Shell synthesis>

To thus obtained halogen-added core particle dispersion liquid, the Zn precursor, the Se precursor, and the S precursor are added and the Zn precursor, the Se precursor, and the S precursor are reacted in the presence of core particles in the dispersion liquid, whereby the shell is formed on the surface of the core particle.

As one embodiment example of the shell synthesis, for example, a method for adding the Zn precursor and the Se precursor to the halogen-added core particle dispersion liquid and thereafter heating the mixture at 150 ~ 300°C and preferably 180 ~ 250°C is included. As one embodiment example of the shell synthesis, for example, a method for adding the Zn precursor and the Se precursor to the halogen-added core particle dispersion liquid, thereafter heating the resultant mixture at 150 ~ 300°C and preferably 180 ~ 250°C, subsequently adding the Zn precursor and the S precursor, and thereafter heating the obtained mixture at 200 ~ 400°C and preferably 250 ~ 350 ° C is included. This shell synthesis method provides the semiconductor nanoparticles in which a shell including ZnSe (first shell) is formed on the surface of the halogen-added core particles and a shell including ZnS (second shell) is further formed on the outside thereof.

As an embodiment example of the synthesis of the shell, for example, a method for adding the Zn precursor, the Se precursor, and, if necessary, the S precursor to the halogen-added core particle dispersion liquid at one time and heating the resultant mixture at 150 ~ 350°C is included. As an embodiment example of the synthesis of the shell, for example, a method for adding the Zn precursor, the Se precursor, and the S precursor into the halogen-added core particle dispersion liquid divided into a plurality of times in a state of heating to 150 ~ 350°C is included. As an embodiment example of the synthesis of the shell, for example, a method for adding the Zn precursor and the Se precursor into the halogen-added core particle dispersion liquid in a state of heating to 150 ~ 350°C and subsequently adding the Zn precursor and the S precursor in a state of heating to 150 ~ 350°C is included. This shell synthesis method provides the semiconductor nanoparticles in which a shell including ZnSe and ZnS is formed on the surface of the halogen-added core particles. In the case where the Zn precursor and Se precursor, and, if necessary, the S precursor serving as the shell precursors are dividedly added in a plurality of times and reacted, the concentrations of each of the shell precursors may be the same in all divided additions or the concentrations of each of the shell precursors may be different in every divided addition. In the case where the shell precursors are dividedly added in a plurality of times and reacted, the heating temperature may be the same in all the divided additions or the heating temperature may be different in every divided addition. Addition of the Te precursor to the shell precursors in the above method allows Te to be included in the shell. Examples of the Te precursor include trioctylphosphine telluride.

### <Purification>

Thus obtained semiconductor nanoparticles can be purified. For example, the semiconductor nanoparticles can be precipitated from the solution by adding a polarity conversion solvent such as acetone. The precipitated semiconductor nanoparticles can be recovered by filtration or centrifugation. The filtrate or supernatant including unreacted starting materials and other impurities can be reused. Subsequently, the recovered semiconductor nanoparticles are washed with a further solvent and thus can dissolve again. This purification operation can be repeated, for example, 2 ~ 4 times or until reaching the desired purity. Examples of other purification methods include agglomeration, liquid-liquid extraction, distillation, electrodeposition, size exclusion chromatography, and ultrafiltration. In the purification, these purification methods can be performed singly or in combination of two or more of these methods.

An oxide layer can be formed on the surface of the semiconductor nanoparticles by adding a surfactant to thus obtained semiconductor nanoparticle, stirring the resultant mixture, thereafter adding an inorganic-containing composition, and stirring the obtained mixture again. The surfactant is not particularly limited and examples thereof include sodium dodecyl sulfate, sodium lauryl sulfate, n-butanol, and dioctyl sodium sulfosuccinate. The inorganic-containing composition is not particularly limited and examples thereof include silane coupling agents, titanate coupling agents, and aluminate coupling agents. For example, after purifying the semiconductor nanoparticles, an aqueous solution including a surfactant is added and the mixed solution is mixed and stirred to form micelles. The formation of the micelles is confirmed by the cloudiness of the mixed solution. The aqueous phase in which micelles are formed is collected, the inorganic-containing composition is added thereto, and the mixture is stirred at 10 ~ 30 ° C for 10 minutes ~ 6 hours. After removing the unreacted material and purifying the resultant product again, the semiconductor nanoparticles having the oxide layer of the oxide can be obtained. The method for forming the outermost layer made of the oxide is not limited to the above method and, for example, a method for adding the inorganic-containing composition at the time of shell synthesis or other known methods are used.

The surface of the semiconductor nanoparticles obtained by the above method may be modified with the ligand. As the method for modifying with the ligand, a known method such as a ligand exchange method is used.

### <Process>

The above operations can be performed in a batch process or at least some of the above operations are also performed in a continuous flow process as described in, for example, International Publication No. 2016/194802, International Publication No. 2017/014314, International Publication No. 2017/014313, and International Application No. PCT/JP2017/016494.

The semiconductor nanoparticle dispersion liquid according to the present invention is a dispersion liquid in which the semiconductor nanoparticles according to the present invention are dispersed in a solvent. Examples of the dispersion medium of the semiconductor nanoparticles include hexane, octadecene, toluene, acetone, and PGMEA (propylene glycol monomethyl ether acetate). The concentration or viscosity of the semiconductor nanoparticles in the semiconductor nanoparticle dispersion liquid according to the present invention is not particularly limited and is appropriately selected depending on a method of use.

The optical member of the present invention includes the semiconductor nanoparticles according to the present invention and is produced by forming into a QD film or a QD pattern using the semiconductor nanoparticle dispersion liquid according to the present invention. For example, the optical member can be produced by dispersing the semiconductor nanoparticle dispersion liquid according to the present invention in a thermosetting resin, thereafter forming the resin into a film or patterning the resin and curing.

### <Wavelength conversion layer>

Examples of the optical member according to the present invention include a QD film and QD patterning including the semiconductor nanoparticles according to the present invention. The semiconductor nanoparticles according to the present invention are suitably used as a wavelength conversion layer (an optical member) such as a QD film that absorbs blue light and converts the blue light into white light and a QD pattern that absorbs blue light and converts the blue light into red light or green light. For example, the QD film and the QD pattern can be obtained by undergoing a film forming step of the semiconductor nanoparticles, a baking step of a photoresist including the semiconductor nanoparticles, or a solvent removal and resin curing step after inkjet patterning of the semiconductor nanoparticles.

### <Measurement>

With respect to the elemental analysis of the semiconductor nanoparticles, elemental analysis can be performed using a high frequency inductively coupled plasma emission spectrometer (ICP) or an X-ray fluorescent analyzer (XRF). In ICP measurement, purified semiconductor nanoparticles are dissolved in nitric acid and heated, thereafter diluted with water to be measured by a calibration curve method using an ICP emission spectrometer (ICPS-8100, manufactured by SHIMADZU CORPORATION). In the XRF measurement, a filter paper impregnated with a dispersion liquid is placed in a sampling holder and a quantitative analysis is performed using an X-ray fluorescent analyzer (ZSX100e, manufactured by Rigaku Corporation).

The optical identification of the semiconductor nanoparticles can be measured using a fluorescence quantum yield measurement system (QE-2100, manufactured by Otsuka Electronics Co., Ltd.) and a visible ultraviolet spectrophotometer (V670, manufactured by JASCO Corporation). A dispersion liquid in which the semiconductor nanoparticles are dispersed in a dispersion medium is irradiated with excitation light to give an emission spectrum. The fluorescence quantum yield (QY) and the full width at half maximum (FWHM) are calculated from the emission spectrum after re-excitation correction in which a re-excitation fluorescence emission spectrum generated by fluorescence emission caused by re-excitation is eliminated from the emission spectrum obtained here. Examples of the dispersion medium include n-hexane, octadecene, toluene, acetone, and PGMEA. The excitation light used for the measurement is determined to be a single light of 450 nm. As the dispersion liquid, a dispersion liquid in which the concentration of the semiconductor nanoparticles is adjusted so that the absorption rate is 20 ~ 30% is used. On the other hand, the absorption spectrum can be measured by irradiating a dispersion liquid in which the semiconductor nanoparticles are dispersed in a dispersion medium with ultraviolet to visible light.

The constitutions, methods, procedures, processes, and the like described in the present specification are examples and do not limit the present invention. A large number of modified aspects can be applied within the scope of the present invention.

Hereinafter, the present invention will be described with reference to specific Experimental Examples. The present invention, however, is not limited thereto.

### [Examples]

The semiconductor nanoparticles were prepared according to the following method and the composition and optical characteristics of the obtained semiconductor nanoparticles were measured.

### (Experimental Example 1)

### <Production of core particles>

Indium acetate (0.3 mmol) and zinc oleate (0.6 mmol) were added to a mixture of oleic acid (0.9 mmol), 1-dodecanethiol (0.1 mmol), and octadecene (10 mL) and the resultant mixture was heated to about 120°C and reacted for 1 hour under vacuum (< 20 Pa). The mixture reacted under vacuum (< 20 Pa) was placed in a nitrogen atmosphere at 25°C and tris(trimethylsilyl) phosphine (0.25 mmol) was added. Thereafter, the mixture was heated to 300°C and reacted for 10 minutes and the reaction solution was cooled to 25°C. Octanoyl chloride (0.45 mmol) was poured into the reaction solution and the resultant mixture was heated at 250°C for 30 minutes and thereafter cooled to 25°C to give a dispersion solution of the core particles.

### <Precursor for shell formation>

To prepare a Zn precursor solution of [Zn] = 0.4 M, 40 mmol of zinc oleate and 75 mL of octadecene were mixed and heated at 110°C for 1 hour under vacuum.

In nitrogen, 22 mmol of selenium powder and 10 mL of trioctylphosphine were mixed and stirred until all components were dissolved to give [Se] = 2.2 M trioctylphosphine selenide.

In nitrogen, 22 mmol of sulfur powder and 10 mL of trioctylphosphine were mixed and stirred until all components were dissolved to give [S] = 2.2 M trioctylphosphine sulfide.

### <Shell formation>

The dispersion solution of the core particles was heated to 250°C. At 250°C, 4.5 mL of the Zn precursor solution and 1.5 mL of trioctylphosphine selenide were added and reacted for 30 minutes to form a ZnSe shell on the surface of the InP-based semiconductor nanoparticles. Furthermore, 4.0 mL of the Zn precursor solution and 0.6 mL of trioctylphosphine sulfide were added and the temperature was raised to 280°C. The reaction was performed for 1 hour to form a ZnS shell.

Observation of the obtained semiconductor nanoparticles by STEM-EDS confirmed that the semiconductor nanoparticles had a core/shell structure.

### <Purification>

Acetone was added to the solution in which thus obtained semiconductor nanoparticles having the core/shell structure were dispersed to aggregate the semiconductor nanoparticles. Subsequently, after centrifugation (4,000 rpm, 10 minutes), the supernatant was removed and the semiconductor nanoparticles were redispersed in hexane. This operation was repeated to give purified semiconductor nanoparticles.

### <Evaluation>

The composition, quantum yield, full width at half maximum of light emission, peak wavelength, and Stokes shift of the purified semiconductor nanoparticles were measured as follows. The results of each of Experimental Examples are listed in Table 1.

### (Composition)

Compositional analysis was performed using a high frequency inductively coupled plasma emission spectrometer (ICP) and an X-ray fluorescent analyzer (XRF).

### (Optical characteristics)

With respect to the optical characteristics, as described above, an emission spectrum was measured using a quantum yield measurement system and the quantum yield (QY), full width at half maximum (FWHM), and peak wavelength (lambda max) were measured. At this time, the excitation light was determined to be a single wavelength of 450 nm. As the dispersion liquid used for the measurement, a dispersion liquid of which concentration was adjusted so that the absorption rate was 20 ~ 30% was used. Furthermore, an absorption spectrum was measured by irradiating the dispersion liquid of the semiconductor nanoparticles with light from the ultraviolet to visible light using an ultraviolet-visible spectrophotometer. As the dispersion liquid used for measuring the absorption spectrum, a dispersion liquid of which concentration was adjusted so that 1 mg of the semiconductor nanoparticles was included in 1 mL of the dispersion medium was used. The difference between the peak wavelength of the emission spectrum of the semiconductor nanoparticles and the peak wavelength of the absorption spectrum of the semiconductor nanoparticles obtained above was calculated as the Stokes shift.

FIG. 4 illustrates the emission spectrum and absorption spectrum of the semiconductor nanoparticles obtained in Experimental Example 2. The broken line represents the absorption spectrum and the solid line represents the emission spectrum. The horizontal axis represents the absorption wavelength for the absorption spectrum and represents the emission wavelength for the emission spectrum. The vertical axis represents the absorbance for the absorption spectrum and represents the emission intensity for the emission spectrum. The Stokes shift corresponds to the difference between the peak wavelength of the emission spectrum (B in FIG. 4) and the peak wavelength of the absorption spectrum of the semiconductor nanoparticles (A in FIG. 4) and the difference between A and B in FIG. 4 represents the Stokes shift. The Stokes shift of the semiconductor nanoparticles illustrated in FIG. 4 was 19.7 nm.

### (Experimental Example 2)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.20 mmol and 1.1 mmol, respectively, that the amounts of added Zn precursor and trioctylphosphine selenide at the time of forming the ZnSe shell were set to 6.0 mL and 2.0 mL, respectively, and that the amounts of added Zn precursor and trioctylphosphine sulfide at the time of forming the ZnS shell were set to 6.0 mL and 1.8 mL, respectively.

### (Experimental Example 3)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.10 mmol and 0.75 mmol, respectively, that the amounts of added Zn precursor and trioctylphosphine selenide at the time of forming the ZnSe shell were set to 6.6 mL and 2.2 mL, respectively, and that the amounts of added Zn precursor and trioctylphosphine sulfide at the time of forming the ZnS shell were set to 4.0 mL and 1.2 mL, respectively.

### (Experimental Example 4)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.30 mmol and 1.1 mmol, respectively, that the amounts of added Zn precursor and trioctylphosphine selenide at the time of forming the ZnSe shell were set to 5.4 mL and 1.5 mL, respectively, and that the amounts of added Zn precursor and trioctylphosphine sulfide at the time of forming the ZnS shell were set to 12.0 mL and 2.1 mL, respectively.

### (Experimental Example 5)

Semiconductor nanoparticles were prepared in the same manner as the manner in Experimental Example 1 except that zinc oleate was not added and the amounts of added tris(trimethylsilyl) phosphine and octanoyl chloride were set to 0.20 mmol and 0.75 mmol, respectively, at the time of preparing the dispersion liquid of core particles, respectively, that the amounts of added Zn precursor and trioctylphosphine selenide at the time of forming the ZnSe shell were set to 3.9 mL and 1.2 mL, respectively, and that the amounts of added Zn precursor and trioctylphosphine sulfide at the time of forming the ZnS shell were set to 4.0 mL and 1.2 mL, respectively.

### (Experimental Example 6)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.18 mmol and 1.2 mmol, respectively, that the amounts of added Zn precursor and trioctylphosphine selenide at the time of forming the ZnSe shell were set to 9.0 mL and 3.0 mL, respectively, and that the amounts of added Zn precursor and trioctylphosphine sulfide at the time of forming the ZnS shell were set to 24.0 mL and 2.8 mL, respectively.

### (Experimental Example 7)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.20 mmol and 0.4 mmol, respectively, that the amounts of added Zn precursor and trioctylphosphine selenide at the time of forming the ZnSe shell were set to 3.0 mL and 1.0 mL, respectively, and the amounts of added Zn precursor and trioctylphosphine sulfide at the time of forming the ZnS shell were set to 2.0 mL and 0.6 mL, respectively.

### (Experimental Example 8)

Semiconductor nanoparticles were prepared in the same manner as the manner in Experimental Example 1 except that trioctylphosphine was added instead of zinc oleate and dodecanethiol and the amount of added tris(trimethylsilyl) phosphine was set to 0.18 mmol at the time of preparing the dispersion liquid of core particles, that the amounts of added Zn precursor and trioctylphosphine selenide at the time of forming the ZnSe shell were set to 12.0 mL and 3.5 mL, respectively, and that the amounts of added Zn precursor and trioctylphosphine sulfide at the time of forming the ZnS shell were set to 15.0 mL and 0.3 mL, respectively.

### (Experimental Example 9)

Semiconductor nanoparticles were prepared in the same manner as the manner in Experimental Example 1 except that 2 mL of trioctylphosphine was added instead of dodecanethiol and the amounts of added tris(trimethylsilyl) phosphine and octanoyl chloride were set to 0.20 mmol and 0.3 mmol, respectively, at the time of preparing the dispersion liquid of core particles, respectively, that the amounts of added Zn precursor and trioctylphosphine selenide at the time of forming the ZnSe shell were set to 4.5 mL and 1.2 mL, respectively, and that the amounts of added Zn precursor and trioctylphosphine sulfide at the time of forming the ZnS shell were set to 3.0 mL and 0.05 mL, respectively.

### (Experimental Example 10)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.20 mmol and 0.5 mmol, respectively, that the amounts of added Zn precursor and trioctylphosphine selenide at the time of forming the ZnSe shell were set to 5.4 mL and 1.5 mL, respectively, and that the amounts of added Zn precursor and trioctylphosphine sulfide at the time of forming the ZnS shell were set to 6.0 mL and 6.0 mL, respectively.

### (Experimental Example 11)

Semiconductor nanoparticles were prepared in the same manner as the manner in Experimental Example 1 except that the amount of added tris(trimethylsilyl) phosphine at the time of preparing the dispersion liquid of core particles was set to 0.15 mmol, that the amounts of added Zn precursor and trioctylphosphine selenide at the time of forming the ZnSe shell were set to 5.4 mL and 1.5 mL, respectively, and that the amounts of added Zn precursor and trioctylphosphine sulfide at the time of forming the ZnS shell were set to 6.0 mL and 1.2 mL, respectively.

### (Experimental Example 12)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.15 mmol and 2.5 mmol, respectively, that the amounts of added Zn precursor and trioctylphosphine selenide at the time of forming the ZnSe shell were set to 7.2 mL and 2.4 mL, respectively, and that the amounts of added Zn precursor and trioctylphosphine sulfide at the time of forming the ZnS shell were set to 6.0 mL and 1.2 mL, respectively.

### (Experimental Reference Example 13)

In nitrogen, 3 mmol of tellurium powder and 10 mL of trioctylphosphine were mixed. The resultant mixture was heated to 250°C and stirred until all components were dissolved to give [Te] = 0.3 M trioctylphosphine telluride.

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.15 mmol and 2.5 mmol, respectively, that the amounts of added Zn precursor and trioctylphosphine selenide at the time of forming the ZnSe shell were set to 7.2 mL and 2.2 mL, respectively, that 5.0 mL of trioctylphosphine telluride was further added at the time of forming the ZnSe shell, and that the amounts of added Zn precursor and trioctylphosphine sulfide at the time of forming the ZnS shell were set to 6.0 mL and 1.2 mL, respectively. The molar ratio of Te relative to In of the obtained semiconductor nanoparticles was 7.60. The analytical values other than Te are listed in Table 1.

### (Experimental Example 14)

A dispersion solution of the core particles was prepared in the same manner as the manner in Experimental Example 1 except that 2 mL of trioctylphosphine was added instead of dodecanethiol and the amounts of added tris(trimethylsilyl) phosphine and octanoyl chloride were set to 0.15 mmol and 2.5 mmol, respectively, at the time of preparing the dispersion liquid of core particles. The dispersion solution of the core particles was heated to 250°C, 8.2 mL of the Zn precursor solution and 2.4 mL of the trioctylphosphine selenide were added at 250°C and the resultant mixture was reacted for 30 minutes to form the ZnSe shell on the surface of the InP-based semiconductor nanoparticles.

As described above, the semiconductor nanoparticles obtained by the present embodiment have the same quantum yield as the semiconductor nanoparticles having the ZnS layer at the outermost layer even when the ZnS layer was not formed at the outermost layer.

### (Experimental Example 15)

Semiconductor nanoparticles were prepared in the same manner as the manner in Experimental Example 1 except that 2 mL of trioctylphosphine was added instead of dodecanethiol and the amounts of added tris(trimethylsilyl) phosphine and octanoyl chloride were set to 0.18 mmol and 4.0 mmol, respectively, at the time of preparing the dispersion liquid of core particles, that the amounts of added Zn precursor and trioctylphosphine selenide at the time of forming the ZnSe shell were set to 7.0 mL and 2.4 mL, respectively, and that the amounts of added Zn precursor and trioctylphosphine sulfide at the time of forming the ZnS shell were set to 12.0 mL and 2.1 mL, respectively.

### (Experimental Example 16)

In nitrogen, 10 mmol of zinc bromide powder and 10 mL of trioctylphosphine were mixed and the resultant mixture was stirred until all components were dissolved to give a bromide precursor.

Semiconductor nanoparticles were prepared in the same manner as the manner in Experimental Example 1 except that 2 mL of trioctylphosphine was added instead of dodecanethiol and the amounts of added tris(trimethylsilyl) phosphine and bromide precursor instead of octanoyl chloride were set to 0.18 mmol and 1.2 mL, respectively at the time of preparing the dispersion liquid of core particles, that the amounts of added Zn precursor and trioctylphosphine selenide at the time of forming the ZnSe shell were set to 7.2 mL and 1.5 mL, respectively, and that the amounts of added Zn precursor and trioctylphosphine sulfide at the time of forming the ZnS shell were set to 4.5 mL and 0.9 mL, respectively.

### (Experimental Example 17)

Semiconductor nanoparticles were prepared in the same manner as the manner in Experimental Example 1 except that the amount of added octanoyl chloride at the time of preparing the dispersion liquid of core particles was set to 1.5 mmol, and that the amounts of added Zn precursor and trioctylphosphine sulfide at the time of forming the ZnS shell were set to 20.0 mL and 3.5 mL, respectively.

### (Experimental Example 18)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.06 mmol and 0.5 mmol, respectively, that the amounts of added Zn precursor and trioctylphosphine selenide at the time of forming the ZnSe shell were set to 4.5 mL and 1.5 mL, respectively, and that the amounts of added Zn precursor and trioctylphosphine sulfide at the time of forming the ZnS shell were set to 8.0 mL and 0.9 mL, respectively.

### (Experimental Example 19)

The amounts of added tris(trimethylsilyl) phosphine and octanoyl chloride at the time of preparing the dispersion liquid of core particles were set to 0.35 mmol and 0.75 mmol, respectively. When tris(trimethylsilyl) phosphine was added and heated, what seemed to be an agglomerate of the semiconductor nanoparticles began to be generated. Semiconductor nanoparticles were prepared as they were in the same manner as the manner in Experimental Example 1 except that the amounts of added Zn precursor and trioctylphosphine selenide at the time of forming the ZnSe shell were set to 5.6 mL and 1.5 mL, respectively, and that the amounts of added Zn precursor and trioctylphosphine sulfide at the time of forming the ZnS shell were set to 4.5 mL and 1.0 mL, respectively. However, the obtained semiconductor nanoparticles were agglomerated and the dispersion liquid in such a degree that the optical characteristics was capable of being measured was difficult to be controlled.

### (Experimental Example 20)

Semiconductor nanoparticles were prepared in the same manner as the manner in Experimental Example 1 except that zinc oleate was not added and the amounts of added tris(trimethylsilyl) phosphine and octanoyl chloride were set to 0.15 mmol and 0.5 mmol, respectively, at the time of preparing the dispersion liquid of core particles, respectively, that the amounts of added Zn precursor and trioctylphosphine selenide at the time of forming the ZnSe shell were set to 3.6 mL and 1.0 mL, respectively, and that the amounts of added Zn precursor and trioctylphosphine sulfide at the time of forming the ZnS shell were set to 3.0 mL and 0.45 mL, respectively.

### (Experimental Example 21)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.18 mmol and 0.9 mmol, respectively, that the amounts of added Zn precursor and trioctylphosphine selenide at the time of forming the ZnSe shell were set to 12.0 mL and 2.5 mL, respectively, and that the amounts of added Zn precursor and trioctylphosphine sulfide at the time of forming the ZnS shell were set to 24.0 mL and 5.0 mL, respectively.

### (Experimental Example 22)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.18 mmol and 0.4 mmol, respectively, that the amounts of added Zn precursor and trioctylphosphine selenide at the time of forming the ZnSe shell were set to 1.8 mL and 0.6 mL, respectively, and that the amounts of added Zn precursor and trioctylphosphine sulfide at the time of forming the ZnS shell were set to 6.0 mL and 0.6 mL, respectively.

### (Experimental Example 23)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.18 mmol and 0.4 mmol, respectively, that the amounts of added Zn precursor and trioctylphosphine selenide at the time of forming the ZnSe shell were set to 12.0 mL and 4.0 mL, respectively, and that the amounts of added Zn precursor and trioctylphosphine sulfide at the time of forming the ZnS shell were set to 15.0 mL and 1.2 mL, respectively.

### (Experimental Example 24)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.15 mmol and 0.2 mmol, respectively, that the amounts of added Zn precursor and trioctylphosphine selenide at the time of forming the ZnSe shell were set to 4.5 mL and 1.5 mL, respectively, and that the amounts of added Zn precursor and trioctylphosphine sulfide at the time of forming the ZnS shell were set to 6.0 mL and 0.6 mL, respectively.

### (Experimental Example 25)

Semiconductor nanoparticles were prepared in the same manner as the manner in Experimental Example 1 except that octanoyl chloride was not added and the amount of added tris(trimethylsilyl) phosphine was set to 0.15 mmol at the time of preparing the dispersion liquid of core particles, that the amounts of added Zn precursor and trioctylphosphine selenide at the time of forming the ZnSe shell were set to 5.4 mL and 1.5 mL, respectively, and that the amounts of added Zn precursor and trioctylphosphine sulfide at the time of forming the ZnS shell were set to 3.0 mL and 0.5 mL, respectively.

### (Experimental Example 26)

Semiconductor nanoparticles were prepared in the same manner as the manner in Experimental Example 1 except that the amounts of added tris(trimethylsilyl) phosphine and octanoyl chloride at the time of preparing the dispersion liquid of core particles were set to 0.28 mmol and 4.5 mmol, respectively, that the amounts of added Zn precursor and trioctylphosphine selenide at the time of forming the ZnSe shell were set to 7.2 mL and 2.4 mL, respectively, and that the amounts of added Zn precursor and trioctylphosphine sulfide at the time of forming the ZnS shell were set to 6.0 mL and 1.2 mL, respectively.

**[Table 1]**

| | Experimental Example | P* | Zn* | Se* | S* | Halogen* | Zn+Se+S | QY Ex. 450 | FWHM [nm] | lambda max [nm] | Stokes shift [nm] |
|---|---|---|---|---|---|---|---|---|---|---|---|
| Examples | 1 | 0.74 | 14.24 | 11.04 | 4.68 | 1.36 | 29.96 | 82 | 33.8 | 531.5 | 20.5 |
| | 2 | 0.52 | 19.32 | 14.44 | 12.26 | 3.89 | 46.01 | 88 | 32.7 | 530.7 | 19.7 |
| | 3 | 0.28 | 15.48 | 14.77 | 9.31 | 2.37 | 39.56 | 86 | 32.5 | 534.5 | 19.5 |
| | 4 | 0.91 | 25.43 | 11.31 | 17.77 | 3.18 | 54.51 | 83 | 32.9 | 530.1 | 20.1 |
| | 5 | 0.62 | 12.39 | 8.62 | 8.68 | 2.30 | 29.69 | 85 | 33.5 | 533.8 | 20.8 |
| | 6 | 0.56 | 46.71 | 20.85 | 21.27 | 3.60 | 88.83 | 87 | 32.7 | 536.1 | 20.1 |
| | 7 | 0.65 | 11.16 | 7.01 | 4.46 | 1.17 | 22.63 | 85 | 33.6 | 536.4 | 20.4 |
| | 8 | 0.59 | 35.23 | 23.91 | 2.39 | 1.35 | 61.53 | 83 | 33.1 | 536.5 | 20.5 |
| | 9 | 0.65 | 11.80 | 9.71 | 0.76 | 0.81 | 22.27 | 81 | 33.7 | 536.1 | 20.1 |
| | 10 | 0.61 | 19.82 | 11.73 | 43.15 | 1.52 | 74.70 | 80 | 33.8 | 534.4 | 21.4 |
| | 11 | 0.44 | 18.09 | 11.51 | 9.13 | 0.81 | 38.73 | 81 | 33.0 | 534.0 | 21.0 |
| | 12 | 0.44 | 20.95 | 16.04 | 9.57 | 7.37 | 46.55 | 88 | 33.6 | 530.4 | 21.4 |
| | 13⁽⁺⁾ | 0.44 | 20.86 | 15.80 | 9.48 | 7.21 | 46.14 | 87 | 34.7 | 530.8 | 21.8 |
| | 14 | 0.45 | 11.60 | 16.31 | 0.00 | 7.51 | 27.91 | 87 | 34.5 | 530.2 | 21.2 |
| | 15 | 0.52 | 28.76 | 15.86 | 15.52 | 14.22 | 60.14 | 88 | 33.3 | 529.8 | 20.8 |
| | 16 | 0.40 | 20.35 | 11.12 | 6.30 | 3.83 | 37.78 | 85 | 33.8 | 527.6 | 21.6 |
| | 17 | 0.82 | 35.10 | 10.87 | 27.86 | 3.73 | 73.83 | 87 | 33.7 | 532.2 | 20.4 |
| Comparative Examples | 18 | 0.19 | 18.55 | 11.20 | 6.83 | 1.39 | 36.58 | 54 | 60.2 | 562.4 | 32.4 |
| | 19 | 1.06 | 16.02 | 11.76 | 7.79 | 2.18 | 35.57 | - | - | - | - |
| | 20 | 0.45 | 9.82 | 7.58 | 3.08 | 1.56 | 20.48 | 62 | 39.2 | 545.9 | 27.9 |
| | 21 | 0.56 | 52.11 | 17.28 | 37.64 | 2.58 | 107.03 | 71 | 37.2 | 533.8 | 24.8 |
| | 22 | 0.50 | 13.21 | 4.05 | 5.02 | 1.07 | 22.28 | 71 | 37.9 | 544.2 | 25.2 |
| | 23 | 0.52 | 38.22 | 27.12 | 5.31 | 1.12 | 70.65 | 72 | 38.5 | 540.7 | 26.7 |
| | 24 | 0.49 | 14.94 | 10.92 | 4.85 | 0.64 | 30.71 | 70 | 37.5 | 530.9 | 24.9 |
| | 25 | 0.50 | 12.83 | 11.74 | 4.14 | 0.00 | 28.71 | 11 | 59.2 | 544.5 | 33.7 |
| | 26 | 0.91 | 33.20 | 17.22 | 17.47 | 15.49 | 67.89 | 60 | 49.4 | 540.3 | 30.7 |

| | | | | | | | | | | | |
|---|---|---|---|---|---|---|---|---|---|---|---|
| * In Table 1, composition values of P, Zn, Se, S, and halogen are each of the molar ratios of P, Zn, Se, S, and halogen relative to In. ⁽⁺⁾ In Table 1, Experimental Example 13 represents a Reference Example | | | | | | | | | | | |

### Reference Signs List

- 1, 101: Blue LED
- 3, 103: Liquid Crystal
- 7, 8: QD Patterning
- 9: Diffusion Layer
- 11: Core
- 12: Shell
- 102: QD Film
- 104: Color Filter (R)
- 105: Color Filter (G)
- 106: Color Filter (B)

## Claims

1. Core/shell type semiconductor nanoparticles, comprising:
a core comprising In and P; and a shell having one or more layers, wherein
at least one layer of the shell is formed of ZnSe,
the semiconductor nanoparticles further comprise halogen,
a molar ratio of the halogen relative to In in terms of atoms is 0.80 ~ 15.00, and
a difference between a peak wavelength of an emission spectrum when the semiconductor nanoparticles are excited at 450 nm and a peak wavelength of an absorption spectrum of the semiconductor nanoparticles is 23 nm or less.

2. A semiconductor nanoparticle dispersion liquid, wherein
the semiconductor nanoparticles as claimed in claim 1 are dispersed in a solvent.

3. An optical member comprising the semiconductor nanoparticles as claimed in claim 1.

## Patentansprüche

1. Halbleiternanopartikel vom Kern/Schale-Typ, umfassend:
einen Kern, der In und P umfasst; und eine Schale mit einer oder mehreren Schichten, wobei
mindestens eine Schicht der Schale aus ZnSe gebildet ist,
die Halbleiternanopartikel weiter Halogen umfassen,
ein Molverhältnis des Halogens zu In, bezogen auf Atome, 0,80 ~ 15,00 beträgt, und
eine Differenz zwischen einer Wellenlänge des Maximums eines Emissionsspektrums, wenn die Halbleiternanopartikel bei 450 nm angeregt werden, und einer Wellenlänge des Maximums eines Absorptionsspektrums der Halbleiternanopartikel höchstens 23 nm beträgt.

2. Dispersion von Halbleiternanopartikeln, wobei
die Halbleiternanopartikel nach Anspruch 1 in einem Lösungsmittel dispergiert sind.

3. Optisches Element, umfassend die Halbleiternanopartikel nach Anspruch 1.

## Revendications

1. Nanoparticules de semiconducteur de type noyau/coque, comprenant :
un noyau comprenant In et P ; et une coque ayant une ou plusieurs couches, dans lesquelles
au moins une couche de la coque est formée de ZnSe,
les nanoparticules de semiconducteur comprennent en outre un halogène,
un rapport molaire de l'halogène par rapport à In en termes d'atomes est de 0,80 ~ 15,00, et
une différence entre une longueur d'onde de pic d'un spectre d'émission lorsque les nanoparticules de semiconducteur sont excitées à 450 nm et une longueur d'onde de pic d'un spectre d'absorption des nanoparticules de semiconducteur est de 23 nm ou moins.

2. Liquide de dispersion à nanoparticules de semiconducteur, dans lequel
les nanoparticules de semiconducteur selon la revendication 1 sont dispersées dans un solvant.

3. Élément optique comprenant les nanoparticules de semiconducteur selon la revendication 1.
